# EUROPEAN PATENT APPLICATION

(11) **EP 1 816 592 A1**
(43) Date of publication of application: **08.08.2007**
(21) Application number: 06101348.8
(22) Date of filing: 06.02.2006
(51) Int. Cl.: G06K 19/077

(54) **Method for producing a RFID tag with at least an antenna comprising two extremities and a integrated circuit chip**

(71) Applicant: Assa Abloy Identification Technology Group AB, 10723 Stockholm (SE)
(72) Inventor: Ayala, Stéphane, 1607 Palézieux Gare (CH)
(74) Representative: Grosfillier, Philippe

(57) **Abstract**

The method comprises the successive following steps:
-) connecting both extremities of a wire antenna each to one of the two conductive parts of a connection module, whereby the single mechanical connection between the wire antenna and the connection module is achieved by said extremities of the wire antenna and then
-) mounting an integrated circuit chip on the connection module.

## Description

### Field of the Invention

The present invention concerns the field of RFID tags and is specifically concerned with the connection of a wire antenna to an integrated circuit.

### State of the art

The direct bonding technology as shown in WO 93/18493 and US 5,281,855 is in principle very interesting because of its simplicity.

For example, in WO 93/18493, the idea is to remove the insulation of the wire by using a hot gas and then to directly bond the wire on the integrated circuit by using ultrasonic welding, thermo-compression welding, soldering or glueing. This document also explains in detail the numerous advantages of the direct bonding technology in comparison with for example the wire bonding method.

In US 5,281,855, the idea is also to provide a means allowing a direct bonding of the wire to an integrated circuit. More specifically in this patent, the wire ends of the antenna are directly attached by soldering, thermal compression bonding or welding to enhanced contact pads made of several layers of deposited metal.

However, such direct bonding techniques have a serious drawback now that the IC are getting smaller in size. It is therefore more and more difficult to realize a direct bonding which is precise and efficient.

Other examples of prior art are disclosed in DE 195 41 039, DE 299 23 853 and DE 201 05 517, all disclosing a direct bonding of a chip module to a wire. In these examples, the chip itself is mounted previously in a chip module with large contact areas which allows to overcome the size problem mentioned above.

In the present case, one wishes to avoid such solutions because chip modules are expensive and submitted to long delays for production and delivery.

Therefore, the solution must allow the use (handle) of a chip alone directly (chips as such being very easy to obtain) in the transponder manufacturing process and use only a minimal amount of additional material beside the antenna and the chip. In particular, large supports on which the whole antenna is printed or embedded are not desired.

### Summary of the invention

Accordingly, it is an aim of the present invention to improve the known devices and methods.

More specifically, it is an aim of the present invention to provide a method that is easy to realize, easy to use and reliable.

It is another aim of the present invention to allow a simple and reliable connection of the antenna to the chip.

Accordingly, an idea of the invention is to connect the extremities of the antenna wire with a connection module, before mounting the integrated circuit chip on the connection module.

It allows to test the connection of the antenna with the module before connection of the chip, saving integrated circuit chips if defaults are measured.

One other important advantage of the invention is that since a chip alone is used instead of a chip module, there is no need to wait until the chip modules are built and delivered.

It is another aim of the present invention to provide a connection module with a very simple structure and a very simple and cheap method to produce such module.

### Detailed description of the invention

The invention will be better understood by the following description and with the accompanying drawings in which:
Figure 1 shows an antenna wire connected to a connection module.
Figure 2 shows the final result of the method of the invention.
Figure 3 shows the method of the invention applied with an alternative type of connection module.
Figure 4 shows a first step of a serial production method of connection modules of the invention.
Figure 5 shows a second step of a serial production method of connection modules of the invention.
Figure 6 shows a particular embodiment of the connection module of the invention.

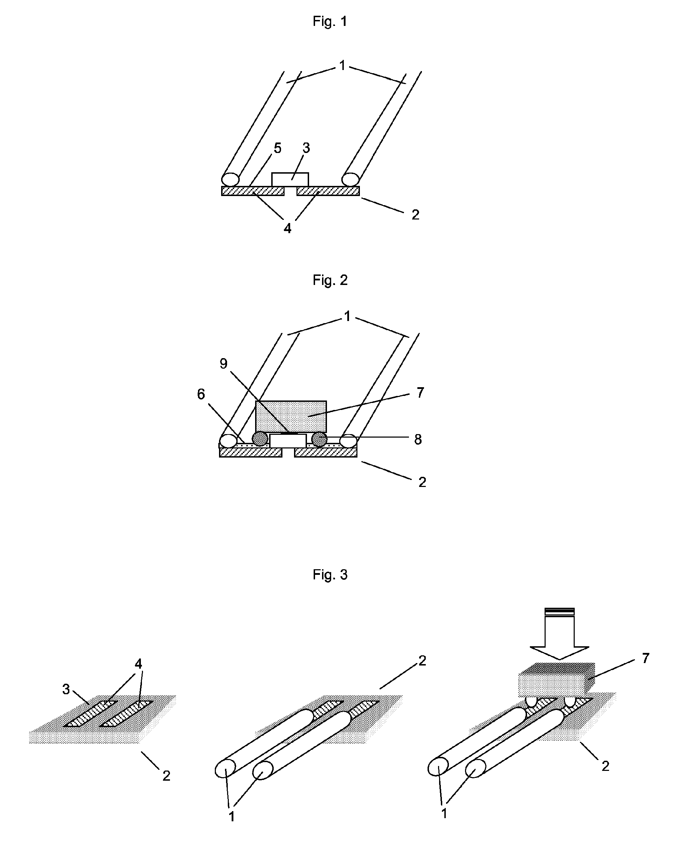

In figure 1, an antenna wire 1 is shown with its two ends connected to the connection module 2. More specifically, the connection module 2 comprises an insulating part 3, two conductive parts 4 with conductive contact surface 5. As represented, the ends of the wire antenna are connected to the contact surfaces 5.

This connection of the antenna to the connection module can be made by known techniques (as taught in the prior art cited above) for example thermo compression, laser welding ? or other.

The antenna wire 1 is typically wound to form a coil (not shown). The winding can be achieved before connecting the wire ends to the connection module 2. Another solution is to connect one end of the wire 1 to the connection module 2, to wind the wire to form the antenna coil and then to connect the other end of the wire to the connection module. In both cases, the result is a wire coil made of a conductive wire connected mechanically and electrically to a connection module without a chip being previously mounted on said module.

An important feature of the invention is that the single mechanical connection between the wire antenna and the connection module is achieved at this point of the process by both extremities of the wire. It means that there is no other mechanical connection of any kind (direct or indirect) between any part of the antenna wire and any part of the connection module. In particular, there is no common support to this two elements. The antenna wire can advantageously be formed as an air coil (without any support), the loops of the coil being held together by known means (as for example adhesive cured coating). Another possibility is that the wire forms a coil wound around a ferrite core for example. Again in such case, there is no mechanical connection (beside the wire) between the ferrite core (supporting only the coil) and the connection module.

In the particular advantageous embodiment shown in figure 1, the connection module 2 is smaller than the antenna. One additional goal of the invention is to use as less as possible additional material beside the antenna and the chip. The dimensions of the connection module have just to be big enough to allow a proper connection of the ends of the wire and the mounting of the chip. Typically, a small multiple of the diameter of the used wire is appropriate. Such a connection module will have surface dimensions comparable to the one of the chip module (with chip mounted inside) cited in the prior art above.

The insulating part 3 is preferably made with a tape of Kapton (trademark) in the form of a sheet of insulation, Kapton (trademark) being a temperature resistant polyimide film produced by the company named DuPont.

The tape could typically be about 500 micrometers large and about 80 micrometers thick. The resulting space between the two conductive sheets could be about 200 micrometer. These dimensions should of course be adapted to the size of the IC chip which has been chosen.
An IC chip 7 provided beforehand with bumps 8 is taken then turned over in order to put in contact the bumps8 with the conductive parts 4 of the module 2. The mounting of the chip 7 on the connection module 2 can be achieved by a flip chip connection, known per se in the art, made with a temperature contribution coming from the pick and place tool, from a hotplate located under the module or even from both.

A drop of glue, or any other adhesive means 9, could be used to fix the chip 7 on the insulating part 3, consolidating the interface module /chip.

Advantageously, the free parts of the conductive parts 4 are coated with a Sn-Pb alloy (conductive coating 6 in figure 2). This facilitates the connection of the antenna wire 1 and of the chip bumps 8. In particular if Sn-Pb ball bumps 8 are used with the chip, this allows a perfect and easily achieved connection using the ball-bonding method.

An alternative is to use stud-bumps. Balls bumps of gold are formed on the chip and elongated to form studs. Such studs are of particular interest to allow a proper connection even if an insulating parts 3 with an important thickness are used. In this case too, a Sn-Pb coating on the free parts of the conductive parts4 is advantageous. A penetration of the gold studs in the coating is facilitated as the coating is smoother than the conductive parts 4 themselves.

The wire antenna is typically made of Copper. The conductive parts 4 could be made of Nickel for example. Of course, these examples are not limiting and other suitable materials can be used.

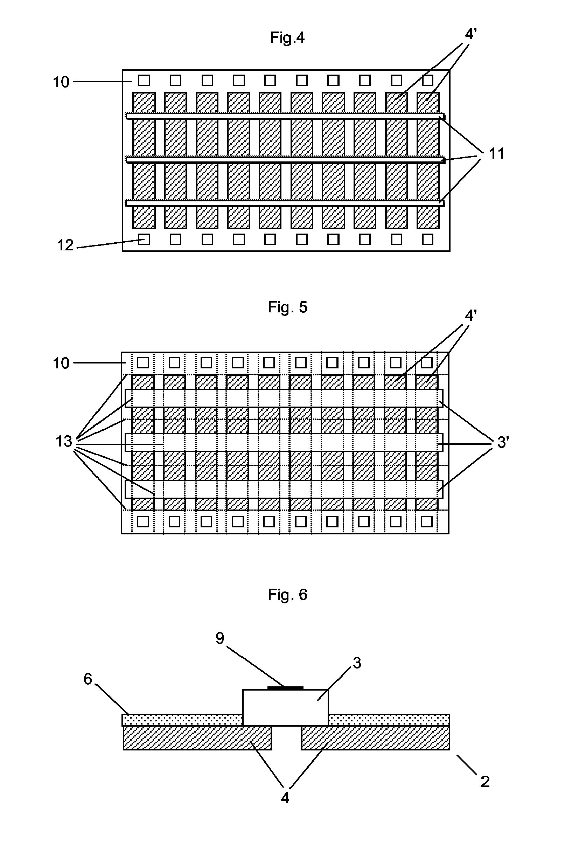

The connection module 2 used in figures 1 and 2 has a very simple structure and is easy to produce. This will be described in more detail in the part of the description relating to the figures 4 to 6. However, it is only given as a non-limiting example..

An alternative form is illustrated in figure 3 , where the connection module 3 is made of an insulating part, for example silicon, on which two conductive parts 4 are added by printing, coating, deposition or another equivalent technology. In this variant, the integrated circuit chip 7 can too be mounted for example by the flip chip method or any other suitable method known in the art.

In figures 4 and 5, a production process of connection module of the invention is represented.

In figure 4 particularly, a series of elongated conductive bands4' have been placed parallel on a support sheet 10. To facilitate the manutention and the positioning of the bands 4', the support sheet 10 could have index holes 12. A serie of elongated holes 11 orientated perpendicularly to the bands 4' have been then punched through both the support sheet 10 and the conductive bands 4'.

As shown in the figure 5, insulating bands 3' have been then deposited over the holes 11, covering a part of bands 4' on which they have been fixed (by adhesive for example). The bands 3' are preferably made with a tape of Kapton (as mentioned already above) and have naturally to be larger than the holes 11. The connection modules have then to be separated by cutting along the cutting lines 13 represented by dotted lines and by picking them away of the support sheet 10, the insulating bands 3' then being transformed into the insulating parts 3, and the conductive bands 4' into the conductive parts 4.

In figure 6, a connection module 2 resulting of the process described according to figure 4 and 5 is represented with its insulating part 3, conductive parts 4, and optional conductive coating 6 and adhesive means 9.

It is to be understood that the embodiments are given by way of examples and that equivalent realizations falling within the scope of the claims are possible. For example, the IC chip can be integrated in a module before being connected to the connection module.

### List of reference numbers :

- 1: antenna wire
- 2: connection module
- 3: insulating part
- 4: conductive part
- 5: conductive contact surface
- 6: conductive coating
- 7: IC chip
- 8: chip bump (ball, stud, ...)
- 9: adhesive
- 10: support sheet
- 11: punched holes
- 12: index holes
- 13: cutting lines
- 3': insulating band
- 4': conductive band

## Claims

1. Method of producing a RFID tag with at least a wire antenna and an integrated circuit chip, the method comprising the successive following steps:
• connecting both extremities of the wire antenna each to one of the two conductive parts of a connection module, whereby the single mechanical connection between the wire antenna and the connection module is achieved by said extremities of the wire antenna
and then
• mounting the integrated circuit chip on the connection module.

2. Method according to claim 1, wherein, before mounting the integrated circuit chip on the connection module, the electrical connections of the antenna with the connection module are tested.

3. Method according to any one of the previous claims, wherein the connection module has dimension of about a small multiple of the wire diameter and /or of the integrated circuit chip.

4. Method according to any one of the previous claims, wherein the integrated circuit chip is mounted on the connection module by flip chip and/or ball-bonding methods.

5. Method according to any one of the previous claims, wherein the chip is connected to the same conductive contact surfaces on which the extremities of the antenna wire are connected.

6. Connection module for use in the method defined in any one of the previous claims, wherein the connection module (2) is made of an insulating part (3) separating two conductive parts (4).

7. Connection module according to claim 6, wherein the insulating part (3) is covering only a part of the front surface of each of the two conductive parts (4).

8. Connection module according to claim 7, wherein the parts of the front surfaces of the two conductive parts (4) not covered by the insulating part (3) are coated by a conductive material (6).

9. Method of manufacturing a connection module as defined in any one of claims 6 to 8, wherein a part of insulating material is fixed on the front surface of two separated parts of conductive material, the part of insulating material covering only a part of each of the front surface of the two conductive parts and maintaining the two conductive parts separated.

10. Method according to claim 9, wherein the parts of the front surfaces of the two conductive parts not covered by the insulating part are coated with a conductive material.
